Europäisches Patentamt

European Patent Office

Office européen des brevets

(19)

(11) **EP 0 632 846 B1**

(12) # EUROPÄISCHE PATENTSCHRIFT

(45) Veröffentlichungstag und Bekanntmachung des Hinweises auf die Patenterteilung:
**03.01.1996 Patentblatt 1996/01**

(21) Anmeldenummer: **93905159.5**

(22) Anmeldetag: **03.03.1993**

(51) Int Cl.6: **C23C 14/00**, C23C 14/50, C23C 16/00 // H01C17/06

(86) Internationale Anmeldenummer:
**PCT/DE93/00201**

(87) Internationale Veröffentlichungsnummer:
**WO 93/19217 (30.09.1993 Gazette 1993/24)**

(54) **EINRICHTUNG ZUM VAKUUMBESCHICHTEN VON MASSENGUT**

ARRANGEMENT FOR VACUUM COATING BULK GOODS

DISPOSITIF A ENDUIRE SOUS VIDE DES PRODUITS EN VRAC

(84) Benannte Vertragsstaaten:
**DE GB NL**

(30) Priorität: **23.03.1992 DE 4209384**

(43) Veröffentlichungstag der Anmeldung:
**11.01.1995 Patentblatt 1995/02**

(73) Patentinhaber: **FRAUNHOFER-GESELLSCHAFT ZUR FÖRDERUNG DER ANGEWANDTEN FORSCHUNG E.V.**
**D-80636 München (DE)**

(72) Erfinder:
• **GOEDICKE, Klaus**
**D-8019 Dresden (DE)**

• **METZNER, Christoph**
**D-8051 Dresden (DE)**
• **SCHMIDT, Jörg**
**D-8021 Dresden (DE)**
• **HEISIG, Ullrich**
**D-8052 Dresden (DE)**
• **SCHILLER, Siegfried**
**D-8051 Dresden (DE)**
• **RESCHKE, Jonathan**
**D-8010 Dresden (DE)**

(56) Entgegenhaltungen:
**DD-A- 257 554**      **DD-A- 293 376**
**US-A- 2 846 971**      **US-A- 3 395 674**
**US-A- 4 116 161**

## Beschreibung

Die Erfindung betrifft eine Einrichtung zum allseitigen Beschichten von relativ kleinen Teilen in hohen Stückzahlen (Massengut). Die Schichten werden durch Hochvakuumbedampfen, Vakuum-Aufstauben (Magnetron-Zerstäuben) und/oder Ionenplattieren (plasmagestütztes Vakuumbedampfen) aufgebracht. Bei den zu beschichtenden Teilen handelt es sich vorzugsweise um Maschinenelemente (Bolzen, Schrauben), aber auch andere Teile, die eine dekorative, harte, verschleißmindernde, elektrisch leitende oder korrosionsschützende Oberfläche erhalten sollen. Auch andere, hier nicht genannte Eigenschaften von Oberflächen sollen erzeugt oder verbessert werden. Es können auch kleine Teile aus Kunststoff oder Keramik nach dem Verfahren beschichtet werden.

Es ist aus der Vakuumbeschichtung bekannt, die zu beschichtenden Teile in geeigneten Halterungen einzuspannen und ein- oder mehrmals durch die Beschichtungszone eines Hochvakuumverdampfers, einer Zerstäubungsquelle oder einer anderen Dampfquelle zur physikalischen Dampfabscheidung (PVD) zu führen und nach Aufbringen der Schichten den Halterungen wieder zu entnehmen. Neben dem Aufwand für die Halterungen und dem Zeitaufwand zur Fixierung und Entnahme der Teile ist der prinzipielle Nachteil vorhanden, daß stets Bereiche der Oberfläche der Teile abgedeckt sind und unbeschichtet bleiben.

Es ist auch bekannt, ähnlich wie bei elektrochemischer Schichtabscheidung (CVD) die Teile als Massengut in einem Korb aus teildurchlässigen Materialien (Drahtgewebe, durchbrochene Bleche) aufzunehmen und zum Zwecke der Beschichtung in die Dampfzone einer PVD-Dampfquelle zu bringen. Dabei rotiert der Korb um eine waagerecht liegende Achse, um eine Mischbewegung der Teile unter Nutzung der Schwerkraft zu erreichen. Anders als bei elektrochemischer Abscheidung aus der flüssigen Phase sind bei PVD-Beschichtungen solche Verfahren wenig geeignet. Es wird eine schlechte Ausnutzung des Dampfes erreicht, und die Öffnungen des Korbes sind nach kurzer Betriebszeit durch Beschichtung verschlossen und nicht mehr wirksam (JP-A 61-194177). Auch eine Schrägstellung der Trommel, bzw. eine exzentrische Lagerung derselben, hat die gleichen Mängel (US-PS 3.517.644). Es ist deshalb versucht worden, den Korb durch Ketten oder durchbrochene Bänder zu ersetzen, gegebenenfalls in Kombination mit Vibrationseinrichtungen, um das Ziel der Beschichtung besser zu erreichen. Die beschriebenen Mängel konnten jedoch nicht wirksam behoben werden, und der apparative Aufwand ist gegenüber dem geringen Vorteil unvertretebar hoch.

Es ist auch bekannt, die zu beschichtenden Teile als Massengut in einem Drehkorb aufzunehmen und eine oder mehrere Zerstäubungsquellen im Inneren des Korbes anzuordnen (DD-PS 257 552 A 3; DD-PS 257 554 A 3). Durch fest mit dem Korb verbundene Vorrichtungen wird erreicht, daß die Teile auf einem Abschnitt des Umfanges mitgeführt werden und dann infolge Schwerkraft zurückrollen. Dadurch wird eine Mischbewegung der Teile beim Beschichtungsvorgang und damit eine allseitige Beschichtung erreicht. Nachteil dieses Verfahrens ist der Umstand, daß nur "von oben nach unten" beschichtet werden kann, d. h. als Beschichtungsquellen können nur Magnetrons eingesetzt werden. Daraus resultiert eine begrenzte Abscheiderate. Die damit verbundenen hohen Beschichtungskosten sind Ursache dafür, dieses Verfahren nur für sehr spezielle Schichten, z. B. sehr dünne Widerstandsschichten anzuwenden. Da sich alle Teile stets unter der Wirkung der Schwerkraft in einem räumlich kleinen Gebiet im unteren Abschnitt des Korbes befinden, ist es auch noch nicht gelungen, gleichzeitig Plasmaquellen während des Beschichtungsvorganges (zum Ionenplattieren) oder eine wirksame Kühlung von temperaturempfindlichen Teilen in das Verfahren einzuführen. Diese bekannten Drehkorb-Zerstäubungsanlagen sind damit auf bestimmte Einsatzgebiete beschränkt.

Zur Beschichtung von Granulat im Vakuum ist es bekannt, dieses in eine Drehtrommel einzubringen, in der sich ein Verdampfer befindet. Diese Trommel rotiert mit so hoher Drehzahl, daß das zu beschichtende Granulat durch die Fliehkraft gegen die Wandung gedrückt wird. Durch eine pulsierende Geschwindigkeitsänderung wird das Granulat umgewälzt, indem es sich vom Umfang löst (DD-PS 293 376). Der Verdampfer ist durch eine Blende abgedeckt, um bei Nichtwirken der Fliehkraft, während der Drehzahlreduzierung, das Fallen von Teilchen in den Verdampfer zu verhindern. Das hat aber den Nachteil, daß dadurch der Dampfstrom ausgeblendet und die Beschichtungsrate erheblich reduziert wird. Einen weiteren Nachteil bringt der Pulsbetrieb mit sich, indem das ständige Abbremsen und Wiederhochfahren der Trommel bei der großen Masse Probleme bereitet. Die Entnahme des beschichteten Granulats ist ebenfalls mit Mängeln behaftet, indem ein Kippen der Trommel erforderlich ist, was eines hohen mechanischen Aufwandes bedarf.

Es ist weiterhin bekannt, eine Vielzahl von Substraten auf dem äußeren Umfang einer rotierenden Trommel oder auf einem Drehteller fest fixiert anzubringen und die Substrate dabei derart zu bewegen, daß jeder Ort der Substratoberfläche periodisch im zeitlichen Abstand durch den Ionenstrom und den Dampfstrom beaufschlagt werden (DD-PS 110 521). Derartige Anlagen weisen jedoch die gleichen Mängel auf wie die zuerst beschriebenen. Die Substrate sind durch die Halterungen zum Teil abgedeckt, und die Be- und Entstückung ist sehr zeitaufwendig.

Es ist eine Vorrichtung zum Beschichten von Massengut bekannt, die aus einer um ihre horizontale Achse rotierenden Trommel besteht. Die Trommel rotiert mit einer derart hohen Drehzahl, daß die in ihr befindlichen Teile durch die Fliehkraft an der Trommeloberfläche gehalten werden. In der Trommel ist die Beschichtungseinrichtung angeordnet (US-A 2,846,971). Diese Vorrichtung weist jedoch den Mangel auf, daß die zu beschichtenden Teile nicht sicher in der Trommel fixiert sind, indem die Oberfläche der Trommel eben ausgeführt ist. Weiterhin wirkt der im Bereich der Trommeloberfläche angeordnete Abstreifstab ständig, wodurch eine Anpassung an den Beschichtungsprozeß nicht gegeben ist. Schließlich ist ein Nachteil, daß die Vorrichtung nur für den Chargenbetrieb geeignet ist.

Der Erfindung liegt die Aufgabe zugrunde, eine Einrichtung zu schaffen, um Kleinteile als Massengut im Vakuum allseitig zu beschichten. Die Beschichtung soll wahlweise aus einem Verdampfertiegel, d. h. aus der flüssigen Phase, oder durch Zerstäuben möglich sein. Die in der PVD-Technik bekannten Mittel zur Verbesserung der Schichteigenschaften (Plasmaeinwirkung bzw. Ionenbeschuß, Kühlung, Heizung usw.) sollen einsetzbar sein. Die Einrichtung soll apparativ nicht wesentlich aufwendiger sein als bekannte Einrichtungen der Vakuumbeschichtung und soll ein hochproduktives Beschichten ermöglichen.

Die Aufgabe wird mit einer Einrichtung gelöst, die aus einer in einem Rezipienten um ihre horizontale Achse rotierenden Trommel besteht, deren Drehzahl konstant gehalten und so hoch ist, daß die in der Trommel befindlichen zu beschichtenden Teile durch die Fliehkraft an der Innenwand der Trommel gehalten werden. In der Trommel sind Strömungswiderstände und Beschichtungseinrichtungen angeordnet. Erfindungsgemäß ist die Innenwand dieser Trommel in ihrer Oberflächenstruktur geometrisch derart ausgebildet, daß die zu beschichtenden Teile in Drehrichtung der Trommel sicher fixiert sind und dadurch an der Innenwand haftend mit ihr bewegt werden. In der Trommel ist eine Abstreifeinrichtung angeordnet, die im Abstand zur Innenwand verstellbar und in programmierbaren Zeitintervallen abschaltbar ist. Diese Abstreifeinrichtung hat eine der Drehrichtung der Trommel entgegengesetzt gerichtete Auflauffläche, um die zu beschichtenden Teile von der Oberfläche der Trommel gut zu lösen. Zweckmäßig ist es, die Auflauffläche gegen die Innenwand der Trommel federnd oder bürstenähnlich auszubilden, um vor allem bei kleinen Teilen ein sicheres Abstreifen von der Innenwand zu gewährleisten.

Bevorzugte Ausführungsformen der erfindungsgemäßen Einrichtung sind in den Ansprüchen 2 bis 15 dargestellt.

Die Wirkung der Einrichtung besteht darin, daß die Trommel mit einer so hohen Geschwindigkeit rotiert, daß die Teile durch die Fliehkraft an den inneren Umfang der Trommel gedrückt und dort fixiert sind und dabei ständig durch die Beschichtungszone bewegt werden. Durch außerhalb der Beschichtungszone, aber in der Trommel angeordnete mechanische Mittel, werden die Teile vom Umfang abgestreift, wodurch eine Lageänderung eintritt. Nach dem Lösen werden sie wieder durch die Fliehkraft an die Innenwand der Trommel gedrückt. Zwangsläufig erfolgt ständig eine Lageänderung der Teile beim zyklischen Durchlaufen der Beschichtungszone, was eine allseitige und gleichmäßige Beschichtung der Teile gewährleistet. Dieser Prozeß wiederholt sich so lange, bis die gewünschte Schichtdicke erreicht ist.

Um ein Herausfallen der zu beschichtenden Teile beim Abstreifen von der Innenwand und dem dabei zwangsweise erfolgenden Mischen zu verhindern, sind vorteilhafterweise die äußeren Ränder der Trommel nach innen hochgezogen.

Für die Herstellung bestimmter Schichten bzw. Schichtsysteme werden die Teile ohne Lageänderung mehrfach durch die Beschichtungszone bewegt. Somit besteht ein Zyklus aus mehreren Beschichtungsdurchläufen zwischen jeder Lageänderung, der sich so oft wiederholt, bis die gesamte Schicht aufgebracht ist. Zur Erzeugung hochwertiger Schichten ist es auch möglich, die durch Fliehkraft am inneren Umfang der rotierenden Trommel fixierten Teile örtlich und zeitlich nacheinander durch die Dampf zone einer Verdampfereinrichtung und die Zone einer Plasma-oder Ionenquelle zu bewegen. Nach jedem Durchlauf werden auch dabei die Teile durch mechanische Mittel von der Trommel abgestreift, um die Lageänderung zu bewirken. Dieser Zyklus wiederholt sich, bis die gesamte Schicht aufgebracht ist.

Handelt es sich bei der Beschichtung um temperaturempfindliche Teile, z. B. aus Kunststoff, ist eine Kühlung der Trommel möglich. Das erfolgt entweder durch Kühlkanäle in der Trommelwand oder eine doppelwandige Ausführung der Trommel, um diese vom Kühlmittel durchströmen zu lassen. Es kann auch noch die Drehzahl der Trommel erhöht werden, um eine höhere Fliehkraft zu erreichen, damit die Teile einen besseren Kontakt zur Trommelwand erfahren, was schließlich die Kühlung verbessert.

Zur Erhöhung der Produktivität und zur Verbesserung der Reproduzierbarkeit des Verfahrens werden die Teile beim Rotieren der Trommel über eine Vakuumschleuse und Leiteinrichtung eingebracht.

Um ein Entleeren der Trommel im rotierenden Zustand zu ermöglichen, ist es zweckmäßig, eine schaltbare Entleerungseinrichtung in der Trommel anzuordnen, die die Teile von der Innenwand der Trommel abstreift oder im Bereich des freien Falls erfaßt und über Leiteinrichtungen über eine Vakuumschleuse auf eine außerhalb der Trommel feststehende Leiteinrichtung befördert. Dadurch kann die Zuführung der Teile ohne Anhalten der rotierenden Trommel erfolgen, und es lassen sich mehrere Chargen nacheinander ohne Vakuumunterbrechung beschichten.

Die innere Wandung der Trommel mit ihrer speziell geometrisch ausgeprägten Oberflächenstruktur bewirkt, daß die Teile an der Wand ohne besondere Halterungen festgehalten werden, d. h., eine ausreichende Haftreibung der Teile vor und nach der Mischphase garantiert ist. Vorzugsweise ist die Oberflächenstruktur durch in axialer Richtung verlaufende Kerben gebildet, deren eine Flanke in Drehrichtung steil und deren andere Flanke entgegen der Drehrichtung der Trommel flach ausgebildet ist. Der Abstand der Kerben soll kleiner sein, als die durchschnittliche Länge der zu beschichtenden Teile. Entsprechende Leiteinrichtungen bewirken im Zusammenwirken mit der Schwerkraft eine Lageänderung der Teile und ein erneutes Fixieren und Weiterbewegen an der Wand der Trommel durch den Beschichtungsraum. In der Trommel sind feststehende Strömungswiderstände angeordnet, um im Zusammenwirken mit dem Gaseinlaß- und Vakuumpumpensystem den Gasdruck und/oder die Gaszusammensetzung während dem Beschichten in der Beschichtungszone zu steuern. Die Blende über der Beschichtungseinrichtung dient zur Unterbrechung der Beschichtung.

Die erfindungsgemäße Einrichtung hat die Vorteile, daß Kleinteile als Massengut, wie beispielsweise Schrauben, Bolzen und Kontaktelemente, im Vakuum allseitig und gleichmäßig zu beschichten sind. Es werden keine Halterungen für diese Teile benötigt. Es sind die verschiedenen Vakuumbeschichtungsarten, wie Bedampfen und Zerstäuben, auch unter Plasmaeinwirkung bzw. Ionenbeschuß anwendbar. Die Einrichtung gewährleistet eine hohe Produktivität, da ein Beschicken und Entleeren ohne Vakuumunterbrechung möglich ist. Die Form der zu beschichtenden Teile kann beliebig sein, ebenso wie die aufzubringenden Schichten.

An einem Ausführungsbeispiel wird die Erfindung näher erläutert. Die zugehörige Zeichnung zeigt in

Figur 1:     eine Einrichtung im Schnitt,

Figur 2:     einen Ausschnitt aus der Wand der Trommel.

Eine horizontal gelagerte Trommel 1, in deren Wand Kühlkanäle 2 angeordnet sind, wird mit so hoher Geschwindigkeit gedreht, daß die zu beschichtenden Teile 3 durch die Fliehkraft gegen die Wand gedrückt und an ihr fixiert werden. Die erforderliche Drehzahl ist

$$n = \frac{1}{t} > \frac{1}{2\pi}\sqrt{\frac{g}{R}}$$

t =     Zeit für eine Umdrehung

n =     Umdrehungszahl der Trommel

g =     Erdbeschleunigung 9,81 ms$^{-2}$

R =     halber Durchmesser der Trommel

Die Fliehkraft muß größer sein als das Eigengewicht der Teile 3.

In der Trommel 1 ist feststehend, jedoch in ihrem Abstand von der Wand der Trommel 1 verstellbar, eine Abstreifeinrichtung 4 angeordnet. Dadurch werden die durch die Fliehkraft an der Wand der Trommel 1 fixierten Teile 3 bei jedem Umlauf oder in bestimmten Zeitabständen, wenn die Abstreifeinrichtung 4 wirksam wird, von der Wand abgestreift und gelangen durch die Schwerkraft nach unten, wodurch sie eine andere Lage einnehmen und wieder an der Wand fixiert werden. Ein Leitblech 5 reguliert den Fall der Teile 3 und bestimmt die Auftreffstelle auf der Innenwand der Trommel 1. In der Trommel 1 ist ein Tiegel eines Elektronenstrahlverdampfers 6 feststehend angeordnet, der mittels einer schwenkbaren Blende 6' verschließbar ist. In Drehrichtung gesehen vor dem Elektronenstrahlverdampfer 6 ist ein Plasma-Ätzer 7 feststehend angeordnet, der von einer Abschirmung 8 umgeben ist. Im Bereich der Abschirmung 8 erfolgt die Zuführung von Reaktionsgas durch die Öffnung 9.

Über eine geeignet angeordnete Fülleinrichtung 10, in Verbindung mit einer Vakuumschleuse (nicht gezeichnet) und Leiteinrichtungen, werden die zu beschichtenden Teile 3 in die rotierende Trommel 1 eingebracht. Ein schwenkbares Leitblech 11, das zum Zwecke des Ausbringens der beschichteten Teile 3 aus der rotierenden Trommel 1 gegen deren Wand geschwenkt wird, leitet die Teile 3 über Leiteinrichtungen (nicht gezeichnet) und eine Entleerungseinrichtung 12, mit integrierter Vakuumschleuse, nach außen. Somit ist das Füllen und Entleeren der Trommel 1 während der Rotation möglich.

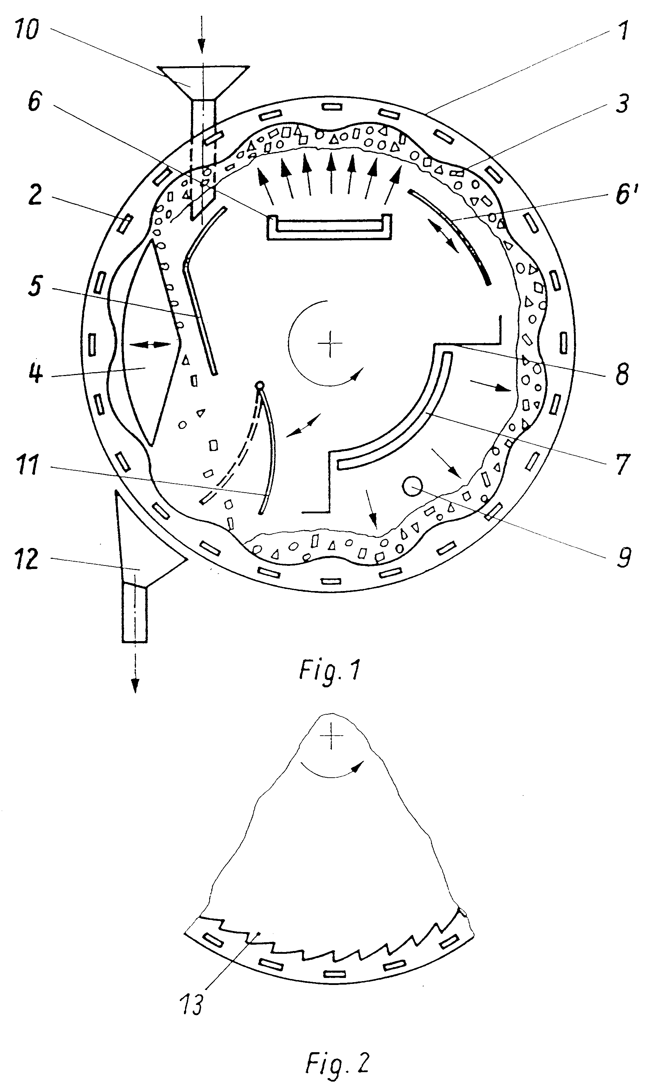

In Figur 2 ist ein Ausschnitt aus der Oberfläche der Trommel 1 gezeigt. Die Oberfläche ist mit axial verlaufenden Kerben 13 versehen. Die Flanke in Drehrichtung ist flach und gegen die Drehrichtung steil ausgebildet. Das bewirkt, daß die Teile 3 besser an der Oberfläche der Trommel 1 haften, d. h. fixiert sind.

**Patentansprüche**

1.  Einrichtung zum Vakuumbeschichten von Massengut durch Bedampfen, Aufstäuben oder plasmaaktiviertes Beschichten, bestehend aus einer um ihre horizontale Achse konstant mit einer solchen Drehzahl rotierenden Trommel, daß in ihr zur Beschichtung befindliche Teile durch die Fliehkraft an der Oberfläche der Trommel gehalten werden, und in der Trommel angeordneten Beschichtungseinrichtungen und Strömungswiderständen, **dadurch gekennzeichnet**, daß die Innenwand der Trommel (1) in ihrer Oberflächenstruktur geometrisch derart ausgebildet ist, daß die zu beschichtenden Teile (3) in Drehrichtung der Trommel (1) sicher fixiert und mit ihr weiterbewegbar sind, und daß in der Trommel (1) eine im Abstand zu ihrer Innenwand verstellbare und in programmierbaren Zeitintervallen abschaltbare Abstreifeinrichtung (4) für die zu beschichtenden Teile (3) mit einer der Drehrichtung der Trommel (1) entgegengesetzt gerichteten Auflauffläche angeordnet ist.

2.  Einrichtung nach Anspruch 1, **dadurch gekennzeichnet**, daß die Oberflächenstruktur der Innenwand der Trommel (1) durch in axialer Richtung verlaufende Kerben (13) gebildet ist, deren Flanken in Drehrichtung steil und entgegen der Drehrichtung flach ausgebildet sind.

3.  Einrichtung nach Anspruch 2, **dadurch gekennzeichnet**,daß der Abstand der Kerben (13) kleiner als die durchschnittliche Länge der zu beschichtenden Teile (3) ist.

4.  Einrichtung nach Anspruch 1 bis 3, **dadurch gekennzeichnet**, daß in der Trommel (1) eine die Teile (3) von deren Innenwand abstreifende oder in einem anderen Bereich aufnehmende Entleerungseinrichtung (12) in Verbindung mit einer Leiteinrichtung (11), über eine Vakuumschleuse nach außen führend, angeordnet ist.

5.  Einrichtung nach Anspruch 1 bis 4, **dadurch gekennzeichnet**, daß in die Wand der Trommel (1) Kühlkanäle (2) eingearbeitet sind, die von Kühlmittel durchströmt sind.

6.  Einrichtung nach Anspruch 1 bis 4, **dadurch gekennzeichnet**, daß die Trommel (1) doppelwandig ausgeführt ist und der Hohlraum vom Kühlmittel durchflossen ist.

7.  Einrichtung nach Anspruch 1 bis 6, **dadurch gekennzeichnet**, daß die Beschichtungseinrichtung mindestens eine Zerstäubungsquelle ist.

8.  Einrichtung nach Anspruch 1 bis 6, **dadurch gekennzeichnet**, daß die Beschichtungseinrichtung mindestens ein Elektronenstrahlverdampfer (6) ist.

9.  Einrichtung nach Anspruch 8, **dadurch gekenn-zeichnet**, daß über jedem Elektronenstrahlver-dampfer (6) eine schwenkbare Blende (6') angeordnet ist.

10. Einrichtung nach Anspruch 1 bis 9, **dadurch gekennzeichnet**, daß außerhalb der Trommel (1) eine feststehende Fülleinrichtung (10) in Verbindung mit einer Vakuumschleuse mit einer in die Trommel (1) führenden Leiteinrichtung angeordnet ist.

11. Einrichtung nach Anspruch 1, **dadurch gekennzeichnet**, daß an der Abstreifvorrichtung (4) an der Auflauffläche gegen die Wand der Trommel (1) federnde Elemente oder Bürsten angebracht sind.

12. Einrichtung nach Anspruch 1 und mindestens einem der Ansprüche 6 bis 11, **dadurch gekennzeichnet**, daß in der Trommel (1) Leitbleche so angeordnet sind, daß die Teile (3) während der Rotation der Trommel (1) von der Mitte der Trommel (1) an den Rand und umgekehrt bewegbar sind.

13. Einrichtung nach Anspruch 1 und mindestens einem der Ansprüche 6 bis 12, **dadurch gekennzeichnet**, daß in der Beschichtungszone ein Elektronenstrahlverdampfer (6) und eine Zerstäubungsquelle angeordnet sind, die durch Strömungswiderstände oder Wände voneinander getrennt sind.

14. Einrichtung nach Anspruch 1 und mindestens einem der Ansprüche 6 bis 13, **dadurch gekennzeichnet**, daß außer dem Elekronenstrahlverdampfer (6) in Drehrichtung vor diesem eine Plasma-oder Ionenquelle (7), vom übrigen Innenraum abgeschirmt, angeordnet ist.

15. Einrichtung nach Anspruch 1 und mindestens einem der Ansprüche 2 bis 14, **dadurch gekennzeichnet**, daß an der Trommel (1) beiderseitig am Umfang nach innen gerichtete Ränder angeordnet sind.

**Claims**

1.  Apparatus for the vacuum coating of bulk goods by vacuum deposition, sputtering or plasma-activated coating, comprising a drum rotating in constant manner about its horizontal axis at a speed such that the pieces for coating located therein are held by centrifugal force on the drum surface, as well as coating devices and flow resistance means located in the drum, characterized in that the inner wall of the drum (1) has a geometrical surface structure such that the pieces (3) to be coated are reliably fixed in the rotation direction of the drum (1) and can be moved on together with the latter, and that in the drum (1) is provided a stripper (4), whose spacing from the inner wall can be adjusted and which can be switched off at programmable time intervals, said stripper for the pieces (3) to be coated being positioned with an abutting surface directed counter to the rotation direction of the drum (1).

2.  Apparatus according to claim 1, characterized in that the surface structure of the inner wall of the drum (1) is formed by axially directed notches (13), whose sides are steep in the rotation direction and shallow counter to the rotation direction.

3.  Apparatus according to claim 2, characterized in that the spacing of the notches (13) is smaller than the average length of the pieces (3) to be coated.

4.  Apparatus according to claims 1 to 3, characterized in that in the drum (1) is provided an emptying device (12) stripping the pieces (3) from the drum inner wall or receiving same in another area so that, in conjunction with a guiding device (11), it passes same outwards via an air lock.

**5.** Apparatus according to claims 1 to 4, characterized in that in the wall of the drum (1) are formed cooling ducts (2) through which flows a coolant.

**6.** Apparatus according to claims 1 to 4, characterized in that the drum (1) has a double wall construction and c oolant flows through the cavity.

**7.** Apparatus according to claims 1 to 6, characterized in that the coating device is at least one sputtering source.

**8.** Apparatus according to claims 1 to 6, characterized in that the coating device is at least one electron beam vaporizer (6).

**9.** Apparatus according to claim 8, characterized in that a pivotable shield (6') is positioned above each electron beam vaporizer (6).

**10.** Apparatus according to claims 1 to 9, characterized in that outside the drum (1) is provided a fixed filling device (10) in conjunction with an air lock with a guiding device leading into the drum (1).

**11.** Apparatus according to claim 1, characterized in that on the abutting surface of the stripper (4) are provided resilient elements or brushes directed against the wall of the drum (1).

**12.** Apparatus according to claim 1 and at least one of the claims 6 to 11, characterized in that in the drum (1) are provided guide plates in such a way that during the rotation of the drum (1) the pieces (3) are movable from the centre of the drum (1) to the edge and vice versa.

**13.** Apparatus according to claim 1 and at least one of the claims 6 to 12, characterized in that in the coating zone are provided an electron beam vaporizer (6) and a sputtering source, which are separated from one another by flow resistance means or walls.

**14.** Apparatus according to claim 1 and at least one of the claims 6 to 13, characterized in that, apart from the electron beam vaporizer (6), in the rotation direction upstream of the latter is provided a plasma or ion source (7) shielded from the remaining inner area.

**15.** Apparatus according to claim 1 and at least one of the claims 2 to 14, characterized in that on either side of the drum (1) on the circumference are provided inwardly directed edges.

**Revendications**

**1.** Dispositif à enduire sous vide des produits en vrac par vaporisation au vide, répartition à l'état pulvérulent, ou enduction à activation plasmatique, comprenant un tambour tournant, autour de son axe horizontal, constamment à une vitesse de rotation appropriée à tenir des pièces, qui se trouvent à son intérieur pour leur enduction, moyennant la force centrifuge, à la surface dudit tambour, et comprenant des moyens enducteurs et des éléments de résistance hydraulique, qui sont disposés dans ledit tambour, **caractérisé en** ce que la structure superficielle de la paroi intérieure dudit tambour (1) a une telle configuration géométrique que lesdites pièces à enduire (3) soient fixées de façon sûre en sens de rotation dudit tambour (1) et aptes à être entraînées ensemble avec le dernier, et en ce qu'à l'intérieur dudit tambour (1) un moyen racleur (4) à détacher lesdites pièces à enduire (3) est disposé, dont l'écart de la paroi intérieur du tambour est ajustable et qui est arrêtable à des intervalles programmables, en étant disposé de façon que sa surface en rampe est dirigée en opposition au sens de rotation dudit tambour (1).

**2.** Dispositif selon la revendication 1, **caractérisé en** ce que la structure superficielle de la paroi intérieure dudit tambour (1) est formée par des rainures (13), qui s'étendent en sens axial et dont les flancs sont dirigés à grande pente en sens de rotation et à plat en sens inverse au sens de rotation.

**3.** Dispositif selon la revendication 2, **caractérisé en** ce que l'écart desdites rainures (13) est plus petit que la longueur moyenne desdites pièces à enduire (3).

**4.** Dispositif selon les revendications 1 à 3, **caractérisé en** ce qu'un moyen de vidage (12), en combinaison avec un moyen de guidage (11), est disposé dans ledit tambour (1) de façon à amener les pièces via un sas à vide à l'extérieur, ledit moyen de vidage détachant lesdites pièces (3) de la paroi intérieure du tambour ou les recevant dans une autre zone.

**5.** Dispositif selon les revendications 1 à 4, **caractérisé en** ce que des canaux de refroidissement (2) sont intégralement formés dans la paroi dudit tambour (1) pour le passage de l'agent réfrigérant.

**6.** Dispositif selon les revendications 1 à 4, **caractérisé en** ce que ledit tambour (1) a une configuration à double paroi et en ce que de l'agent réfrigérant passe à travers ce creux.

**7.** Dispositif selon les revendications 1 à 6, **caractérisé en** ce que le dispositif à enduire constitue au moins une source de pulvérisation.

8.  Dispositif selon les revendications 1 à 6, **caractérisé en** ce que le dispositif à enduire constitue au moins un évaporateur à faisceaux électroniques (6).

9.  Dispositif selon la revendication 8, **caractérisé en** ce qu'un écran pivotable (6') est disposé au dessus de chaque évaporateur à faisceaux électroniques (6).

10. Dispositif selon les revendications 1 à 9, **caractérisé en** ce qu'un moyen de remplissage stationnaire (10), en combinaison avec un sas à vide à un moyen de guidage qui s'étend à l'intérieur dudit tambour (1), est disposé au dehors dudit tambour (1).

11. Dispositif selon la revendication 1, **caractérisé en** ce que des éléments ou brosses élastiques sont disposés audit moyen racleur (4) sur ladite surface en rampe, de façon à faire ressort contre la paroi dudit tambour (1).

12. Dispositif selon la revendication 1 et au moins une quelconque des revendications 6 à 11, **caractérisé en** ce que des chicanes sont disposées dans ledit tambour (1) de façon à permettre, au cours de la rotation dudit tambour (1), un mouvement desdites pièces (3) du centre dudit tambour (1) vers la périphérie et en sens inverse.

13. Dispositif selon la revendication 1 et au moins une quelconque des revendications 6 à 12, **caractérisé en** ce qu'un évaporateur à faisceaux électroniques (6) et une source de pulvérisation sont disposés dans la zone d'enduction, qui sont séparés l'un de l'autre par des éléments de résistance hydraulique ou moyennant des parois.

14. Dispositif selon la revendication 1 et au moins une quelconque des revendications 6 à 13, **caractérisé en** ce qu'en plus dudit évaporateur à faisceaux électroniques (6), une source de plasma ou d'ions (7), blindée contre le reste de l'intérieur, est disposée en amont de l'évaporateur, vue en sens de rotation.

15. Dispositif selon la revendication 1 et au moins une quelconque des revendications 2 à 14, **caractérisé en** ce que des bords périphérique, de part et d'autre, qui sont dirigés vers l'intérieur, sont disposés au tambour (1).

Fig. 1

Fig. 2